# EUROPÄISCHE PATENTSCHRIFT

(11) **EP 1 486 106 B1**
(45) Veröffentlichungstag und Bekanntmachung des Hinweises auf die Patenterteilung: **02.11.2005**
(21) Anmeldenummer: 03704379.1
(22) Anmeldetag: 11.01.2003
(51) Int. Cl.: H05K 7/20, H02B 1/56

(54) **KÜHLANORDNUNG**
COOLING ARRAY
ENSEMBLE DE REFROIDISSEMENT

(30) Priorität: 11.03.2002 DE 10210480
(43) Veröffentlichungstag der Anmeldung: 15.12.2004
(73) Patentinhaber: Rittal GmbH & Co. KG, 35726 Herborn (DE)
(72) Erfinder: NICOLAI, Michael, 35466 Rabenau (DE); DÖRRICH, Martin, 35764 Sinn (DE)
(74) Vertreter: Fleck, Hermann-Joseph
(86) Internationale Anmeldenummer: PCT/EP2003/000212
(87) Internationale Veröffentlichungsnummer: WO 2003/077625

(56) Entgegenhaltungen:
- EP-A- 0 767 601
- DE-C- 3 931 570
- DE-U- 7 500 696
- US-A- 4 514 746
- US-A- 5 406 807
- US-A1- 2002 007 641
- US-A1- 2002 021 557

## Beschreibung

Die Erfindung betrifft eine Kühlanordnung mit einem Einbauten aufnehmenden Gehäuse und mit einer Klimatisierungseinrichtung, die über eine kühlmittelführende Vorlaufleitung und eine Rücklaufleitung mit einer Wärmequelle der elektrischen Einbauten in Verbindung steht, dass von der Vorlaufleitung mehrere Gerätezulauf- und von der Rücklaufleitung Geräterücklaufleitungen abgehen, wobei einem elektrischen Einbau wenigstens eine Gerätezulauf- und wenigstens eine Geräterücklaufleitung zugeordnet ist, wobei von der Klimatisierungseinrichtung eine Zulaufleitung und eine Rückflußleitung abgeht, die an die Vorlaufleitung und die Rücklaufleitung angeschlossen sind.

Eine Kühlanordnung dieser Art ist durch die US-A 4,514,746 bekannt. Bei diesem bekannten Aufbau stellen die einzelnen Leitungen, die die Verbindung zur Klimatisierungseinrichtung und zu den Verbrauchern, d. h. den elektrischen, zu kühlenden Einbauten, ein komplettes System dar, das auf eine ganz bestimmte Anzahl von Einbauten ausgelegt ist. Daher kann der Aufbau der Kühlanordnung nicht auf einfache Weise verändert und die Anzahl der Einbauten reduziert und/oder vergrößert werden.

Um eine flexible Kühlanordnung zu erhalten, sieht die Erfindung vor, dass die Anschlüssevon Kupplungsvorrichtungen gebildet sind, und dass die Kupplungsverbindungen als tropffrei trenn- und fügbare Kupplungen ausgebildet sind, dass die Vorlaufleitung und/oder die Rücklaufleitung als starre Profilschenkel ausgebildet sind, die einen Führungskanal für die Kühlflüssigkeit, beispielsweise Wasser, bilden.

Mit diesen Kupplungsvorrichtungen lassen sich die elektrischen Einbauten individuell an- und abschalten, ohne den übrigen Kreislauf der anderen Einbauten in der Kühlanordnung nicht zu beeinträchtigen. Zudem können die als starre Profilschenkel mit Führungsphase für die Kühlflüssigkeit ausgebildete Vorlauf- und/oder Rücklaufleitung im Schaltschrank leicht verlegt werden und stehen über die gesamte Schaltschrankhöhe als Anschlussmöglichkeit für elektrische Einbauten zur Verfügung.

Die Vorlauf- und die Rücklaufleitung sind mit einer Klimatisierungseinrichtung verbunden, die eine auf dem Verdampferprinzip arbeitende Anlage sein kann.

Die Gerätezulauf- und die Geräterücklaufleitungen weisen endseitig Koppelstücke auf, die mit entsprechend ausgebildeten Gegen-Koppelstücken zu Kupplungsverbindungen fügbar sind.

Eine mögliche Ausgestaltungsvariante der Erfindung kann dadurch gekennzeichnet sein, dass das Gehäuse ein Schaltschrank ist, der in seinem rückseitigen Bereich einen Aufnahmeraum für die vertikal verlaufende Vorlaufleitung und die Rücklaufleitung bildet.

Um bei dieser Anordnung eine problemlose Entlüftung zu erreichen, kann es vorgesehen sein, dass die Vorlaufleitung mit der Rücklaufleitung im Dachbereich des Gehäuses über eine Verbindungsleitung übergeleitet ist, und dass in die Verbindungsleitung eine Entlüftung integriert ist.

Die verfügbare Kälteleistung an einem elektrischen Einbau kann auf einfache Weise variiert werden, wenn vorgesehen ist, dass die den elektrischen Einbauten zugeleitete Kühlmittelmenge mittels eine in die Gerätezulauf- oder in die Geräterücklaufleitung integrierten Begrenzers steuerbar ist.

Gemäß einer bevorzugten Erfindungsvariante kann es vorgesehen sein, dass die Vorlaufleitung und/oder die Rücklaufleitung als starre Profilschenkel ausgebildet sind, die einen Führungskanal für die Kühlflüssigkeit, beispielsweise Wasser, bilden. Der Profilschenkel kann beispielsweise ein Strangpreßprofil sein.

Gemäß einer bevorzugten Ausgestaltungsvariante der Erfindung kann es auch vorgesehen sein, dass das Gehäuse ein Traggestell mit vertikalen Rahmenprofilen aufweist, und dass in wenigstens einem Rahmenprofil die Vorlauf- und/oder die Rücklaufleitung integriert ist.

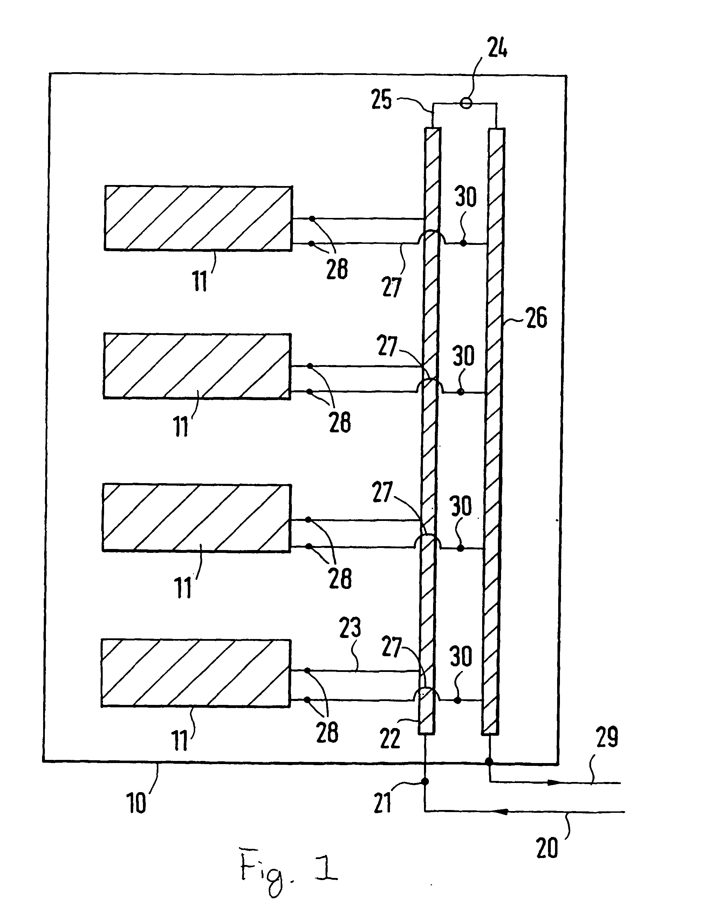

Die Erfindung wird im Folgenden anhand eines in der Zeichnung dargestellten Ausführungsbeipieles näher erläutert.

Die Zeichnung zeigt in schematischer Darstellung eine Kühlanordnung. In einem Gehäuse 10 sind dabei eine vertikal verlaufende Vorlaufleitung 22 und eine Rücklaufleitung 26 angeordnet. Innerhalb des Gehäuses 10 sind auch elektrische Einbauten 11 untergebracht. Diese weisen Wärmequellen auf, die zu kühlen sind. Hierzu gehen geräteindividuell von der Vorlaufleitung 22 je eine Gerätezulaufleitung 23 und von der Rücklaufleitung 26 eine Geräterücklaufleitung 27 ab. Die elektrischen Einbauten 11 sind dabei zueinander parallel geschaltet an die Vorlaufleitung 22 beziehungsweise die Rücklaufleitung 26 angeschlossen. Der Anschluß der Einbauten 1 1 an das kühlmittelführende System erfolgt mittels tropffrei füg- und trennbarer Kopplungsverbindungen 28.

Zur Regelung der Kälteleistung pro Einbau 11 ist ein Begrenzer 30 in die Geräterücklaufleitung integriert. Dieser regelt die Kühlmittel-Durchflußmenge.

Die Vorlaufleitung 22 und die Rücklaufleitung 26 sind über Kupplungsverbindungen 21 an eine Zulaufleitung 20 beziehungsweise Rücklaufleitung 29 angeschlossen. Diese führen zu einer, in der Zeichnung nicht dargestellten Klimatisierungseinrichtung. In dieser wird die Wärme aus dem Kühlmittel abgetauscht (vorzugsweise Wasser).

Um eine Entlüftung des Systems durchführen zu können, ist im Bereich einer Verbindungsleitung 25 eine Entlüftung 24 eingebaut. Die Verbindungsleitung 25 ist im Bereich des Gehäusedaches angeordnet.

## Patentansprüche

1. Kühlanordnung mit einem elektrische Einbauten (11) aufnehmenden Gehäuse (10) und mit einer Klimatisierungseinrichtung, die über eine kühlmittelführende Vorlaufleitung (22) und eine Rücklaufleitung (26) mit einer Wärmequelle der elektrischen Einbauten in Verbindung steht, dass von der Vorlaufleitung (22) mehrere Gerätezulauf- (27) und von der Rücklaufleitung (26) Geräterücklaufleitungen (23) abgehen, wobei einem elektrischen Einbau (11) wenigstens eine Gerätezulauf- (27) und wenigstens eine Geräterücklaufleitung (23) zugeordnet ist, wobei von der Klimatisierungseinrichtung eine Zulaufleitung (20) und eine Rückflußleitung (29) abgeht, die an die Vorlaufleitung (22) und die Rücklaufleitung (26) angeschlossen sind,
**dadurch gekennzeichnet,**
**dass** die Anschlüsse von Kupplungsverbindungen (21) gebildet sind und
**dass** die Kupplungsverbindungen als tropffrei trenn- und fügbare Kupplungen ausgebildet sind,
**dass** die Vorlaufleitung (22) und/oder die Rücklaufleitung (26 als starre Profilschenkel ausgebildet sind, die einen Führungskanal für die Kühlflüssigkeit, beispielsweise Wasser, bilden.

2. Kühlanordnung nach Anspruch 1,
**dadurch gekennzeichnet,**
**dass** die Gerätezulauf- (27) und die Geräterrücklaufleitungen (23) endseitig Koppelstücke aufweisen, die mit entsprechend ausgebildeten Gegen-Koppelstücken zu Kupplungsverbindungen (28) fügbar sind.

3. Kühlanordnung nach Anspruch 1 oder 2,
**dadurch gekennzeichnet,**
**dass** das Gehäuse (10) ein Schaltschrank ist, der in seinem rückseitigen Bereich einen Aufnahmeraum für die vertikal verlaufende Vorlaufleitung (22) und die Rücklaufleitung (28) bildet.

4. Kühlanordnung nach Anspruch 3,
**dadurch gekennzeichnet,**
**dass** die Vorlaufleitung (22) mit der Rücklaufleitung (26) im Dachbereich des Gehäuses (10) über eine Verbindungsleitung (25) übergeleitet ist, und
**dass** in die Verbindungsleitung (25) eine Entlüftung (24) integriert ist.

5. Kühlanordnung nach einem der Ansprüche 1 bis 4,
**dadurch gekennzeichnet,**
**dass** die den elektrischen Einbauten (11) zugeleitete Kühlmittelmenge mittels eines in die Gerätezulauf- (27) oder in die Geräterücklaufleitung (23) integrierten Begrenzers (30) steuerbar ist.

6. Kühlanordnung nach einem der Ansprüche 1 is 5,
**dadurch gekennzeichnet,**
**dass** der Profilschenkel als Strangpressprofil ausgebildet sind.

7. Kühlanordnung nach einem der Ansprüche 1 bis 6,
**dadurch gekennzeichnet,**
**dass** das Gehäuse (10) ein Traggestell mit vertikalen Rahmenprofilen aufweist, und
**dass** in wenigstens einem Rahmenprofil die Vorlauf- (22) und/oder die Rücklaufleitung (26) integriert ist.

## Claims

1. Cooling arrangement having a housing (10) which accommodates internal electrical components (11), and having an air-conditioning device which is connected to a heat source of the internal electrical components via a coolant-carrying feed line (22) and a return line (26) by a plurality of appliance inflow lines (23) branching off from the feed line (22) and appliance return lines (27) branching off from the return line (26), with an internal electrical component (11) having at least one associated appliance inflow line (23) and at least one associated appliance return line (27), and with one inflow line (20) and one return line (29), which are connected to the feed line (22) and the return line (26), branching off from the air-conditioning device,
**characterized**
**in that** the connections are formed by coupling connections (21), and
**in that** the coupling connections are in the form of couplings which can be separated and joined in a leaktight manner, and
**in that** the feed line (22) and/or the return line (26) are/is in the form of rigid profiled limbs which form a guide channel for the cooling liquid, for example water.

2. Cooling arrangement according to Claim 1,
**characterized**
**in that** the ends of the appliance inflow lines (23) and the appliance return lines (27) have coupling elements which can be joined to corresponding mating coupling elements to form coupling connections (28).

3. Cooling arrangement according to Claim 1 or 2,
**characterized**
**in that** the housing (10) is a switchgear cabinet whose rear region forms an accommodation space for the vertically running feed line (22) and the return line (26).

4. Cooling arrangement according to Claim 3,
**characterized**
**in that** the feed line (22) is linked to the return line (26) in the upper region of the housing (10) via a connection line (25), and
**in that** a ventilation arrangement (24) is integrated in the connection line (25).

5. Cooling arrangement according to one of Claims 1 to 4,
**characterized**
**in that** the amount of coolant supplied to the internal electrical components (11) can be controlled by means of a limiter (30) which is integrated in the appliance inflow line (23) or in the appliance return line (27).

6. Cooling arrangement according to one of Claims 1 to 5,
**characterized**
**in that** the profiled limb is in the form of an extruded profile.

7. Cooling arrangement according to one of Claims 1 to 6,
**characterized**
**in that** the housing (10) has a support frame with vertical frame profiles, and
**in that** the feed line (22) and/or the return line (26) are/is integrated in at least one frame profile.

## Revendications

1. Ensemble de refroidissement avec un boîtier (10) recevant des éléments électriques intégrés (11) et avec un dispositif de climatisation, qui est en liaison par le biais d'une conduite d'aller (22) conduisant du réfrigérant et d'une conduite de retour (26) avec une source de chaleur des éléments électriques intégrés, plusieurs conduites d'amenée à l'appareil (23) partant de la conduite d'aller (22) et plusieurs conduites de retour de l'appareil (27) partant de la conduite de retour (26), au moins une conduite d'amenée à l'appareil (23) et au moins une conduite de retour de l'appareil (27) étant associées à un élément électrique intégré (11), une conduite d'amenée (20) et une conduite de reflux (29) partant du dispositif de climatisation, lesquelles sont raccordées à la conduite d'aller (22) et à la conduite de retour (26),
**caractérisé en ce que**
les raccords sont formés par des connexions d'accouplement (21) et **en ce que** les connexions d'accouplement sont réalisées sous forme d'accouplement séparables et joignables sans goutte, **en ce que** la conduite d'aller (22) et/ou la conduite de retour (26) sont réalisées sous forme de branches profilées rigides qui forment un canal de guidage pour le liquide de refroidissement, par exemple de l'eau.

2. Ensemble de refroidissement selon la revendication 1,
**caractérisé en ce que**
les conduites d'amenée à l'appareil (23) et les conduites de retour de l'appareil (27) présentent des pièces d'accouplement au niveau des extrémités, qui peuvent être assemblées avec des pièces d'accouplement conjuguées réalisées de manière correspondante pour former des connexions d'accouplement (28).

3. Ensemble de refroidissement selon la revendication 1 ou 2,
**caractérisé en ce que**
le boîtier (10) est une armoire électrique qui forme dans sa région arrière un espace de réception pour la conduite d'aller (22) s'étendant verticalement et pour la conduite de retour (26).

4. Ensemble de refroidissement selon la revendication 3,
**caractérisé en ce que**
la conduite d'aller (22) est transférée à la conduite de retour (26) dans la région du plafond du boîtier (10) par le biais d'une conduite de connexion (25) et **en ce qu'**un désaérage (24) est intégré dans la conduite de connexion (25).

5. Ensemble de refroidissement selon l'une quelconque des revendications 1 à 4,
**caractérisé en ce que**
la quantité de réfrigérant acheminée aux éléments électriques intégrés (11) peut être commandée au moyen d'un limiteur (30) intégré dans la conduite d'amenée à l'appareil (23) ou dans la conduite de retour de l'appareil (27).

6. Ensemble de refroidissement selon l'une quelconque des revendications 1 à 5,
**caractérisé en ce que**
la branche profilée est réalisée sous forme de profilé filé.

7. Ensemble de refroidissement selon l'une quelconque des revendications 1 à 6,
**caractérisé en ce que**
le boîtier (10) présente un bâti porteur avec des profilés de cadre verticaux, et
**en ce que** la conduite d'aller (22) et/ou de retour (26) est intégrée dans au moins un profilé de cadre.
